# EUROPEAN PATENT SPECIFICATION

(11) **EP 3 581 948 B1**
(45) Date of publication and mention of the grant of the patent: **24.02.2021**
(21) Application number: 19176417.4
(22) Date of filing: 24.05.2019
(51) Int. Cl.: G01R 31/36, G01R 31/67

(54) **APPARATUS FOR VERIFYING ELECTRICAL CONNECTIVITY**
VORRICHTUNG ZUR ÜBERPRÜFUNG DER ELEKTRISCHEN KONNEKTIVITÄT
APPAREIL DE VÉRIFICATION DE CONNECTIVITÉ ÉLECTRIQUE

(30) Priority: 25.05.2018 KR 20180059581
(43) Date of publication of application: 18.12.2019
(73) Proprietor: Samsung SDI Co., Ltd., Gyeonggi-do (KR)
(72) Inventor: BAE, Jeongguk, Gyeonggi-do (KR); SEO, Giho, Gyeonggi-do (KR)
(74) Representative: Mounteney, Simon James

(56) References cited:
- US-A1- 2007 216 356
- US-A1- 2009 237 035
- US-A1- 2010 182 155
- US-A1- 2015 309 118
- US-A1- 2016 069 945
- US-A1- 2016 238 665

## Description

### BACKGROUND

### 1. Field

One or more embodiments relate to an apparatus for verifying electrical connectivity.

### 2. Description of the Related Art

With the development of electric vehicles, energy storage device technology, and the like, technologies relating to battery packs have advanced, and there is a trend toward designing battery packs having higher operating voltage and capacity for driving such devices.

As described above, since battery packs are designed to have high voltage and capacity, it has become more important to verify whether the electrical connection between a battery pack and a device is complete. Prior art US2010/182155, US2007/216356, and US2009/237035 teach circuits for determining whether a battery is connected to a charger. Prior art US2015/309118 teaches a circuit for determining the state of a safety plug in a battery. Prior art US2016/069945 discloses a circuit for determining a faulty connection in a car battery. Prior art US2016/238665 discloses a circuit for measuring the resistance of a battery connector.

### SUMMARY

One or more embodiments include an apparatus for securely verifying the electrical connectivity between two electronic devices to be coupled to each other.

One or more embodiments include an apparatus for securely verifying the electrical connectivity between two devices while preventing a signal used for the verification from being distorted, or at least reducing the extent to which it is distorted, by noise generated from at least one of the two devices.

One or more embodiments include an apparatus configured to be manufactured with lower costs for verifying electrical connectivity.

Additional aspects will be set forth in part in the description which follows and, in part, will be apparent from the description, or may be learned by practice of the presented embodiments.

According to one or more embodiments, there is provided an apparatus for verifying electrical connectivity between a first device and a second device, the apparatus including: a signal generator configured to generate a first signal having a voltage waveform, under control of a processor; a second device connection unit configured to transmit the first signal to the second device and acquire a second signal output from the second device in response to the first signal; a processor connection unit configured to transmit the first and second signals to the processor; a current controller configured to control a magnitude of current such that the first signal has a given current value; and the processor configured to verify the electrical connectivity between the first and second devices based on the first and second signals received through the processor connection unit.

The given current value may be greater than a current value caused by, or expected to be caused by, noise. Said noise may be noise generated by the first device and/or the second device.

The first device may comprise said apparatus. The apparatus may be the first device. The apparatus may be included in the first device. The apparatus may be configured to verify electrical connectivity between the apparatus and the second device.

When the first and second signals received through the processor connection unit correspond to each other, the processor may be configured to determine that the electrical connectivity between the first and second devices is verified.

The first signal may have a predetermined characteristic. When the second signal has the predetermined characteristic, the processor may be configured to determine that the electrical connectivity between the first and second devices is verified.

The first signal may be a time-varying waveform having said predetermined characteristic. When the second signal is a time-varying waveform having said predetermined characteristic, the processor may be configured to determine that the electrical connectivity between the first and second devices is verified. The time-varying waveform may be a square-wave signal. The predetermined characteristic may be a period.

The first signal may be a square-wave signal having a given period, and when the second signal is a square-wave signal having the given period, the processor may be configured to determine that the electrical connectivity between the first and second devices is verified.

The first signal may be at least one of a square-wave signal having a given period and a linear signal having only a power supply voltage, and when the second signal is a linear signal having only a ground voltage, the processor may be configured to determine that the first and second devices are in one of a state in which the first and second devices are electrically disconnected from one another and a state in which the second device is shorted to ground.

The first signal may be at least one of a time varying waveform having a predetermined characteristic and a linear signal having only a power supply voltage, and when the second signal is a linear signal having only a ground voltage, the processor may be configured to determine that the first and second devices are in one of a state in which the first and second devices are electrically disconnected from one another and a state in which the second device is shorted to ground.

The first signal may be a square-wave signal having a given period, and when the second signal is a linear signal having only a power supply voltage, the processor may be configured to determine that the second device is shorted to a power supply.

The first signal may be a time varying waveform having a predetermined characteristic, and when the second signal is a linear signal having only a power supply voltage, the processor may be configured to determine that the second device is shorted to a power supply.

The second device connection unit may include: a signal transmission unit configured to transmit the first signal to the second device; and a signal acquisition unit configured to acquire the second signal from the second device.

The second device may form a first closed circuit having the signal transmission unit and the signal acquisition unit as a start point and an end point, respectively. The apparatus may be configured to cause the first signal to be transmitted through a second closed circuit in which the signal generator, the signal transmission unit, the first closed circuit, the signal acquisition unit, and the current controller are connected in series to each other.

When the first signal is transmitted through the second closed circuit, the current controller may be configured to adjust a current value in the second closed circuit to be equal to the given current value.

When the first signal is transmitted through the second closed circuit, the given current value may be greater than a current value caused by noise.

When the first signal is transmitted through the second closed circuit, the given current value may be greater than a current value expected to be caused by noise.

The first device may be a battery pack, and the second device may be an electronic device configured to be driven by the battery pack, wherein the apparatus may be configured to be connected in parallel to the first device and in series to the second device through the second device connection unit.

Before the first device is connected to the second device, the apparatus may be configured to be connected in series to the second device through the second device connection unit and may verify the electrical connectivity between the first and second devices.

According to a further embodiment there is provided a method for verifying electrical connectivity between a first device and a second device. The method comprises providing an apparatus for verifying electrical connectivity between a first device and a second device, the apparatus including: a signal generator configured to generate a first signal having a voltage waveform, under control of a processor; a second device connection unit configured to transmit the first signal to the second device and acquire a second signal output from the second device in response to the first signal; a processor connection unit configured to transmit the first and second signals to the processor; a current controller configured to control a magnitude of current such that the first signal has a given current value; and the processor configured to verify the electrical connectivity between the first and second devices based on the first and second signals received through the processor connection unit. The method further comprises causing, by the processor, the signal generator to generate the first signal having a voltage waveform; transmitting, by the second device connection unit, the first signal to the second device; acquiring, by the second device connection unit, the second signal output from the second device in response to the first signal; transmitting, by the processor connection unit, the first and second signals to the processor; controlling, by the current controller, the magnitude of current such that the first signal has the given current value; and verifying, by the processor, the electrical connectivity between the first and second devices based on the first and second signals received through the processor connection unit.

The method may further comprise connecting the apparatus in parallel with the first device and in series with the second device through the second device connection unit.

The method may further comprise, before the first device is connected to the second device: connecting the apparatus in series to the second device through the second device connection unit; and verifying the electrical connectivity between the first and second devices.

It will be appreciated that features described in the context of, or in combination with, one embodiment of the present disclosure may be used in combination with other embodiments described herein. For example, features described in combination with a method described above, may be combined with the apparatus also described above, and vice versa.

At least some of the above features that accord with the invention, and other features according to the invention, are set out in the claims.

### BRIEF DESCRIPTION OF THE DRAWINGS

These and/or other aspects will become apparent and more readily appreciated from the following description of the embodiments, taken in conjunction with the accompanying drawings in which:
FIG. 1 is a view illustrating a configuration of an apparatus for verifying electrical connectivity, according to an embodiment;
FIGS. 2 and 3 are views illustrating a closed circuit formed by the apparatus for verifying electrical connectivity and a second device, according to an embodiment;
FIG. 4 is a view illustrating example results of determination of the electrical connectivity between two devices according to types of first and second signals;
FIG. 5 is view illustrating examples of first and second devices according to an embodiment; and
FIG. 6 is a view illustrating an example of the apparatus for verifying electrical connectivity, according to an embodiment.

### DETAILED DESCRIPTION

Reference will now be made in detail to embodiments, examples of which are illustrated in the accompanying drawings. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.

Advantages and features of the present disclosure, and implementation methods thereof will be clarified through the following descriptions given with reference to the accompanying drawings. However, the following embodiments of the present disclosure are non-limiting examples and may have different forms, and it should be understood that the idea and technical scope of the present disclosure cover all the modifications, equivalents, and replacements. Rather, these embodiments are provided so that this disclosure will be thorough and complete, and will fully convey the scope of the present disclosure to those skilled in the art. Moreover, detailed descriptions related to well-known functions or configurations will be omitted in order not to unnecessarily obscure subject matters of the present disclosure.

For example, specific shapes, structures, and features described in one example embodiment may be modified in another example embodiment without departing from the scope of the present disclosure. In addition, the positions or arrangement of elements described in one example embodiment may be changed in another example embodiment within the scope of the present disclosure. That is, the following description is provided for illustrative purposes only and is not intended to limit the scope of the present disclosure. The scope of the present disclosure is defined by the claims and equivalents thereof. In the drawings, like reference numerals denote like elements. Details described in the present disclosure are examples. That is, such details may be changed in other example embodiments within the scope of the present disclosure.

It will be understood that although the terms "first," "second," etc. may be used herein to describe various elements, these elements should not be limited by these terms. These terms are only used to distinguish one element from another.

The terminology used herein is for explaining specific embodiments only and is not intended to limit the scope of the present disclosure. The terms of a singular form may include plural forms unless otherwise mentioned. It will be understood that terms such as "comprise," "include," and "have," when used herein, specify the presence of state features, integers, steps, operations, elements, components, or combinations thereof, but do not preclude the presence or addition of one or more other features, integers, steps, operations, elements, components, or combinations thereof.

Hereinafter, example embodiments will be described in detail with reference to the accompanying drawings. In the drawings, like reference numerals denote like elements, and overlapping descriptions thereof will be omitted.

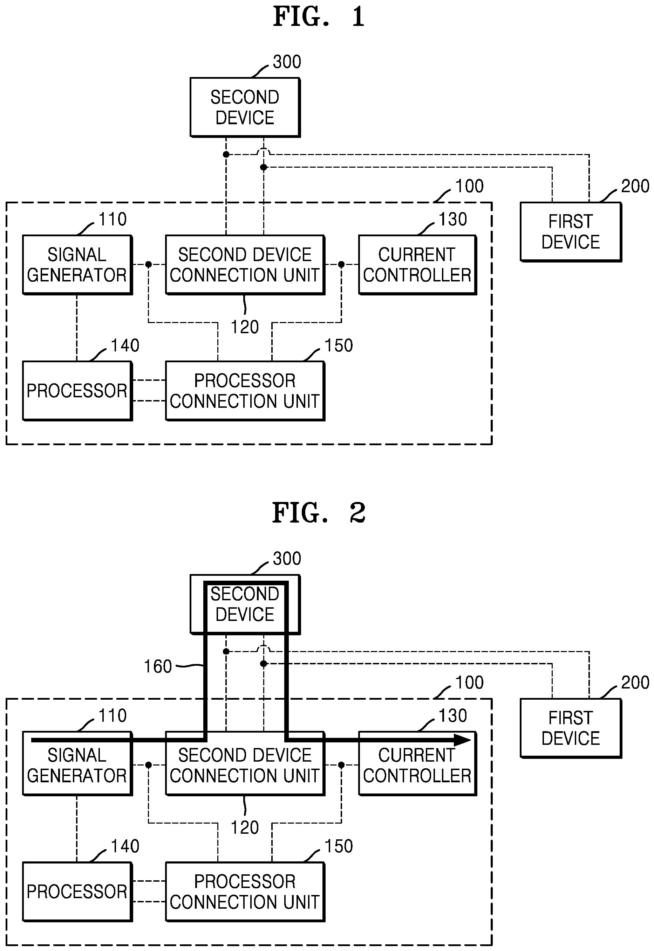

FIG. 1 is a view illustrating a configuration of an apparatus 100 for verifying electrical connectivity according to an embodiment.

The apparatus 100 for verifying electrical connectivity according to the embodiment may verify the electrical connectivity between a first device 200 and a second device 300. For example, when the first device 200 is a battery pack and the second device 300 is an electronic device configured to be driven by the battery pack, the apparatus 100 for verifying electrical connectivity may verify the electrical connectivity between the first device 200 and the second device 300 before the first device 200 (battery pack) is turned on, to prevent accidents that may occur as the first device 200 and the second device 300 are connected to each other. The apparatus 100 may comprise the first device 200. The apparatus 100 may be included in the first device 200. Thus, by verifying a connection between the apparatus 100 and the second device 300 it is possible to, in effect, verify a connection between the first device 200 and the second device 300.

As shown in FIG. 1, the apparatus 100 for verifying electrical connectivity may include a signal generator 110, a second device connection unit 120, a current controller 130, a processor 140, and a processor connection unit 150.

In addition, the apparatus 100 for verifying electrical connectivity according to the embodiment may be electrically connected to the first and second devices 200 and 300 to verify the electrical connectivity between the first and second devices 200 and 300. For example, as shown in FIG. 1, the apparatus 100 for verifying electrical connectivity may be connected in parallel to the first device 200 and in series to the second device 300. It will be understood that the apparatus 100 may be connected to terminals of the first device in such a way that the apparatus 100 may interact with the second device 300 independently of the components of the first device 200 (or other components of the first device, where the apparatus 100 is within the first device 200). That is, electrical signals are not required to pass through components of the first device 200 when travelling between the apparatus 100 and the second device 300. However, signals which are transmitted from the apparatus 100 to the second device 300 will pass through some part of the second device 300 before passing back to the apparatus 100, meaning that a series circuit is formed.

According to the embodiment, the signal generator 110 may generate a first signal having a given voltage waveform under the control of the processor 140 (described later). At this time, the first signal generated by the signal generator 110 may be transmitted through a closed circuit formed by the apparatus 100 for verifying electrical connectivity and the second device 300. The closed circuit will be described later.

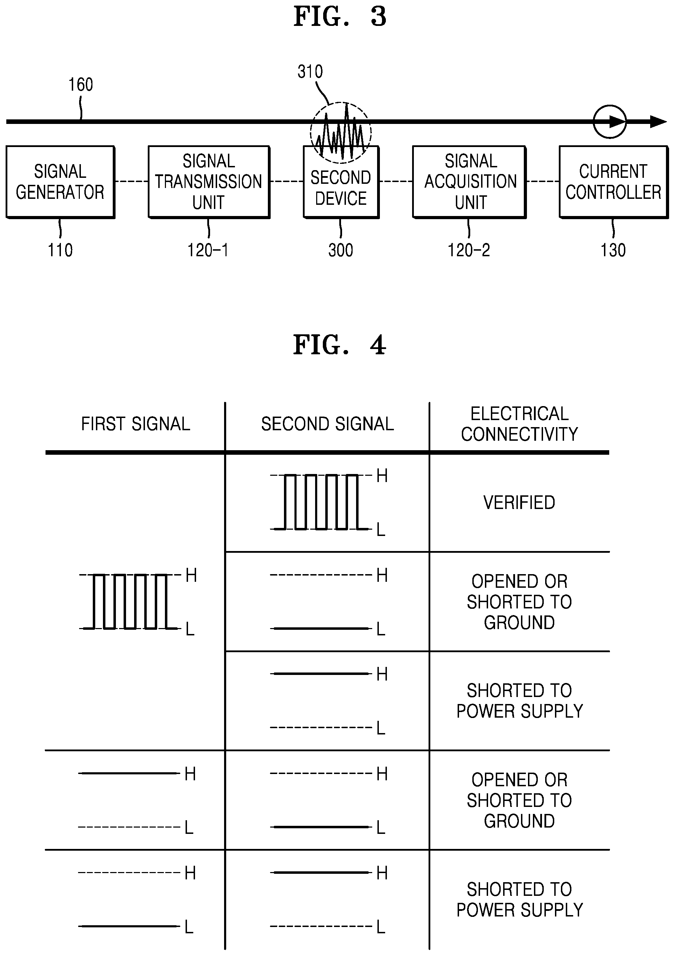

In addition, the signal generator 110 may generate first signals having various voltage waveforms under the control of the processor 140 (described later). For example, as shown in FIG. 4, the signal generator 110 may generate a square-wave signal having a given period, or a linear signal having only a power supply voltage or ground voltage. However, the above-described forms of first signals are examples, and embodiments are not limited thereto. For example, a square-wave signal having a given period may be considered to be an example of a time-varying waveform having a given period. Further, a time-varying waveform having a given period may itself be considered to be an example of a time-varying waveform having a predetermined characteristic. In general terms, the signal generator 110 may generate a time-varying waveform having a predetermined characteristic. More generally still, the signal generator 110 may generate the first signal so as to cause the first signal to have a predetermined characteristic.

The second device connection unit 120 of the embodiment may transmit a first signal generated by the signal generator 110 to the second device 300 and may acquire a second signal output from the second device 300 in response to the first signal. To this end, the second device connection unit 120 of the embodiment may include: a signal transmission unit 120-1 (refer to FIG. 3) configured to transmit a first signal generated by the signal generator 110 to the second device 300; and a signal acquisition unit 120-2 (refer to FIG. 3) configured to acquire a second signal output from the second device 300 in response to the first signal.

The processor connection unit 150 of the embodiment may be configured to enable monitoring of the first signal and the second signal. For example, as illustrated in Fig. 1, the processor connection unit 150 may be configured to enable monitoring of the first signal between the signal generator 110 and the second device connection unit 120. The processor connection unit 150 may be further configured to enable monitoring of the second signal between the second device connection unit 120 and the current controller 130. The processor connection unit 150 may transmit the first signal and the second signal to the processor 140. In this case, the first and second signals transmitted to the processor 140 through the processor connection unit 150 may be used to check the electrical connectivity between the first device 200 and the second device 300.

The current controller 130 of the embodiment may operate such that the first signal having a voltage waveform and transmitted through the closed circuit formed by the apparatus 100 for verifying electrical connectivity and the second device 300 may have a current value. For example, the current controller may comprise a current source or sink (e.g. comprising a current mirror), configured to cause a current having a predetermined magnitude to flow from the signal generator 110 to the current controller 130 along a circuit which is described in more detail below.

In the related art, when the electrical connectivity between the first device 200 and the second device 300 are verified, only the voltage of the signal is considered, and thus the electrical connectivity between the first device 200 and the second device 300 may not be properly verified due to the influence of noise.

However, according to the embodiment, the apparatus 100 for verifying electrical connectivity uniformly controls even the current value of the first signal having a given voltage waveform. Therefore, the influence of noise may be reduced, and thus the electrical connectivity between two devices may be more reliably verified. That is, by causing the first signal to have a current value (e.g. a predetermined current magnitude value), the risk that noise is of greater magnitude than the first signal may be reduced. It will, of course, be appreciated that an appropriate current value may be selected by the skilled person based upon the expected noise level of a particular system.

The processor 140 of the embodiment may check the electrical connectivity between the first device 200 and the second device 300 based on the first signal and the second signal transmitted through the processor connection unit 150. For example, when the first signal and the second signal transmitted through the processor connection unit 150 correspond to each other, the processor 140 may determine that the electrical connectivity between the first device 200 and the second device 300 is verified. In this case, the expression "two signals 'correspond to' each other" may mean that the two signals are identical to each other or are within the range in which the two signals are considered to be identical to each other. Alternatively, or in addition, when the first signal and the second signal transmitted through the processor connection unit 150 both comprise a predetermined characteristic, the processor 140 may determine that the electrical connectivity between the first device 200 and the second device 300 is verified.

The processor 140 may control the voltage waveform of the first signal generated by the signal generator 110 as described above.

For example, the processor 140 may refer to a data processing device included in hardware and having a physically structured circuit to execute codes of programs or functions expressed with instructions. Examples of the data processing device included in hardware may include a microprocessor, a central processing unit (CPU), a processor core, a multiprocessor, an application-specific integrated circuit (ASIC), and a field programmable gate array (FPGA). However, embodiments are not limited thereto.

In an alternative embodiment, the processor 140 may be a device included in the first device 200. For example, the first device 200 may be a battery pack, and the processor 140 may be a device included in a battery management system (BMS) of the battery pack or may be the BMS. However, this is an example, and embodiments are not limited thereto. The apparatus 100 may be provided within the first device 200.

FIGS. 2 and 3 are views illustrating a closed circuit 160 formed by the apparatus 100 for verifying electrical connectivity and the second device 300 according to an embodiment.

As described above, a first signal generated by the signal generator 110 may be transmitted to the second device 300 through the second device connection unit 120, and a second signal output from the second device 300 in response to the first signal may be transmitted back to the apparatus 100 for verifying electrical connectivity through the second device connection unit 120.

In other words, the first signal may be transmitted through the closed circuit 160 formed by the signal generator 110, the second device connection unit 120, and the second device 300. In this case, the current controller 130 placed in the closed circuit 160 may maintain the magnitude of current of the first signal at a constant level in the closed circuit 160.

This will now be described with reference to FIG. 3. The first signal may be transmitted through the closed circuit 160 formed by the signal generator 110, the signal transmission unit 120-1 of the second device connection unit 120, the second device 300, the signal acquisition unit 120-2 of the second device connection unit 120, and the current controller 130.

It will be understood that at least two connections may be made at each of the apparatus 100 and the second device 300. For example, a first connection may be made to the signal transmission unit 120-1 of the second device connection unit 120, and a second connection may be made to the signal acquisition unit 120-2 of the second device connection unit 120. At the second device, a first connection may be made which receives the signal transmitted from the signal transmission unit 120-1, and a second connection may be made which emits the signal back to the signal acquisition unit 120-2. As such, there may be provided two independent connections between the apparatus 100 and the second device 300. It will be understood that the connections will be made to the apparatus 100 at at least two separate connection points or terminals, and to the second device 300 at at least two separate connection points or terminals.

In this case, the current controller 130 may maintain the magnitude of current of the first signal such that the current value of the first signal may be less affected by noise 310 generated in the second device 300, and thus the electrical connectivity between the first and second devices 200 and 300 may be more reliably verified.

FIG. 4 illustrates example results of determination of the electrical connectivity between the first and second devices 200 and 300 according to types of first and second signals.

As described above, when first and second signals received through the processor connection unit 150 correspond to each other, the processor 140 may determine that the electrical connectivity between the first device 200 and the second device 300 is verified. In this case, the expression "two signals 'correspond to' each other" may mean that the two signals are identical to each other or are within the range in which the two signals are considered to be identical to each other, or substantially identical to each other.

When the first signal is a square-wave signal having a given period and the second signal is also a square-wave signal having the same period as the first signal, the processor 140 may determine that the electrical connectivity between the first device 200 and the second device 300 is verified. Of course, when the first signal is a time-varying signal having a given characteristic other than a square-wave signal, the processor 140 may determine that the electrical connectivity between the first device 200 and the second device 300 is verified based upon the second signal also having the given characteristic.

However, when the first signal is a square-wave signal having a given period but the second signal is a linear signal having only a ground voltage, the processor 140 may determine this situation as one of the state in which the first device 200 and the second device 300 are electrically opened (i.e. disconnected from one another) and the state in which the second device 300 is shorted to ground.

In addition, similarly, when the first signal is a square-wave signal having a given period but the second signal is a linear signal having only a power supply voltage, the processor 140 may determine that the second device 300 is shorted to a power supply. In this case, the ground voltage may refer to one of a ground voltage and a reference voltage, and the power supply voltage may refer to the voltage of the power supply used to drive the first device 200 and/or the apparatus 100.

In addition, when the first signal is a linear signal having only the power supply voltage and the second signal is a linear signal having only the ground voltage, the processor 140 may determine this situation as one of the state in which the first device 200 and the second device 300 are electrically opened (i.e. disconnected from one another) and the state in which the second device 300 is shorted to ground.

Conversely, when the first signal is a linear signal having only the ground voltage and the second signal is a linear signal having only the power supply voltage, the processor 140 may determine that the second device 300 is shorted to the power supply.

It will be understood that the coupling within the second device 300 between the connection points of the second device 300 will have an impact upon the nature of the similarity between the first and second signals. For example, if the two the connection points are connected together within the second device 300 (and not also shorted to ground/a power supply), the second signal will generally be the same as the first signal. However, if the two the connection points are isolated from one another within the second device 300, the second signal will generally be independent from the first signal and will not allow the electrical connectivity between the first and second devices 200 and 300 to be verified.

In this manner, the processor 140 of the embodiment may variously verify the electrical connectivity between the first and second devices 200 and 300 based on first and second signals.

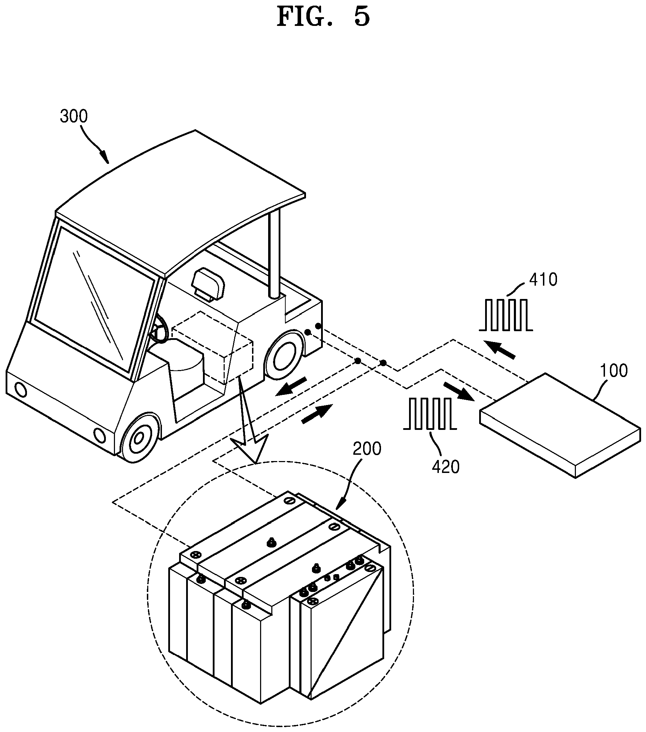

FIG. 5 is view illustrating examples of the first device 200 and the second device 300 according to an embodiment.

As shown in FIG. 5, for example, the first device 200 may be a battery pack, and the second device 300 may be a cart configured to be driven by the battery pack. While shown separately, the apparatus 100 may be provided within, or as part of, the first device 200.

In this case, before the first device 200 is connected to the second device 300, the apparatus 100 for verifying electrical connectivity may be connected in series to the second device 300 to verify the electrical connectivity between the first device 200 and the second device 300.

In other words, the apparatus 100 for verifying electrical connectivity may transmit a first signal 410 to the second device 300 and may acquire a second signal 420 output from the second device 300 in response to the first signal 410 to verify the electrical connectivity between the first and second devices 200 and 300 by comparing the first and second signals 410 and 420.

Furthermore, in the present disclosure, the expression "before the first device 200 is connected to the second device 300" may mean that the system is in a state in which wiring for connecting the first device 200 and the second device 300 to each other is set up as shown in FIG. 5, but that the first device 200 and the second device 300 are not yet electrically connected to each other because an internal switch of the first device 200 is turned off.

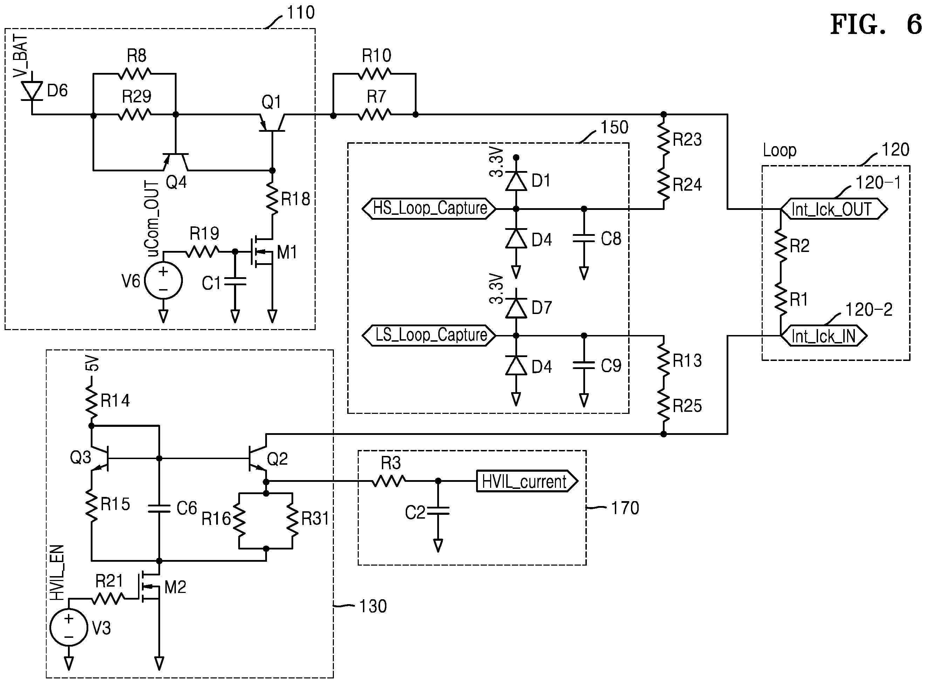

FIG. 6 is a view illustrating an example of the apparatus 100 for verifying electrical connectivity according to an embodiment.

As described above, the apparatus 100 for verifying electrical connectivity may include: a signal generator 110 configured to generate a first signal having a given voltage waveform under the control of a processor 140 (refer to FIG. 1); a second device connection unit 120 configured to transmit the first signal to a second device 300 (refer to FIG. 1) and acquire a second signal output from the second device 300 in response to the first signal; a processor connection unit 150 configured to transmit the first and second signals to the processor 140 (refer to FIG. 1); a current controller 130 configured to control the magnitude of current of the first signal such that the first signal may have a given current value; and a current monitoring unit 170 configured to deliver the current value controlled by the current controller 130 to the processor 140.

In this case, as described above, the second device connection unit 120 may include a signal transmission unit 120-1 configured to transmit the first signal to the second device 300 (refer to FIG. 1), and a signal acquisition unit 120-2 configured to acquire the second signal from the second device 300 (refer to FIG. 1). The signal transmission unit 120-1 and the signal acquisition unit 120-2 may be coupled together within the second device connection unit 120 by a high impedance coupling (e.g. a high value resistor). Such a coupling may permit an attenuated version of the first voltage signal transmitted from 120-1 to be coupled to the signal acquisition unit 120-2 even in the absence of a connection via the second device 300. However, it will be understood that any such signal will be significantly attenuated, and will therefore be readily distinguished from the second signal output from the second device 300 in response to the first signal.

As described above, according to the one or more of the above embodiments, when two electronic devices are coupled, the electrical connectivity between the two electronic devices may be more securely verified.

In particular, according to the present disclosure, when a signal having a voltage waveform is used for verifying the electrical connectivity between two devices, even the current value of the signal may be controlled for more secure verification of the electrical connectivity between the two devices.

In addition, according to the present disclosure, the apparatus 100 for verifying electrical connectivity may be manufactured with low manufacturing costs.

It should be understood that embodiments described herein should be considered in a descriptive sense only and not for purposes of limitation. Descriptions of features or aspects within each embodiment should typically be considered as available for other similar features or aspects in other embodiments.

While one or more embodiments have been described with reference to the figures, it will be understood by those of ordinary skill in the art that various changes in form and details may be made therein without departing from the scope of the invention, which is defined by the following claims.

## Claims

1. An apparatus (100) for verifying electrical connectivity between a first device (200) and a second device (300), the apparatus comprising:
a signal generator (110) configured to generate a first signal having a voltage waveform;
a processor (140) configured to control the signal generator;
a second device connection unit (120) configured to transmit the first signal to the second device and acquire a second signal output from the second device in response to the first signal;
a processor connection unit (150) configured to transmit the first and second signals to the processor;
a current controller (130) configured to control a magnitude of current such that the first signal has a given current value; and
the processor configured to verify the electrical connectivity between the first and second devices based on the first and second signals received through the processor connection unit.

2. The apparatus of claim 1, wherein, when the first and second signals received through the processor connection unit correspond to each other, the processor is configured to determine that the electrical connectivity between the first and second devices is verified.

3. The apparatus of claim 2, wherein the first signal has a predetermined characteristic, and when the second signal has the predetermined characteristic, the processor is configured to determine that the electrical connectivity between the first and second devices is verified.

4. The apparatus of claim 3, wherein the first signal is a time-varying waveform having said predetermined characteristic, and
when the second signal is a time-varying waveform having said predetermined characteristic, the processor is configured to determine that the electrical connectivity between the first and second devices is verified.

5. The apparatus of any preceding claim, wherein the first signal is a square-wave signal having a given period, and
when the second signal is a square-wave signal having the given period, the processor is configured to determine that the electrical connectivity between the first and second devices is verified.

6. The apparatus of any preceding claim, wherein the first signal is at least one of a time varying waveform having a predetermined characteristic and a linear signal having only a power supply voltage, and
when the second signal is a linear signal having only a ground voltage, the processor is configured to determine that the first and second devices are in one of a state in which the first and second devices are electrically disconnected from one another and a state in which the second device is shorted to ground.

7. The apparatus of any preceding claim, wherein the first signal is a time varying waveform having a predetermined characteristic, and
when the second signal is a linear signal having only a power supply voltage, the processor is configured to determine that the second device is shorted to a power supply.

8. The apparatus of claim any preceding claim, wherein the second device connection unit comprises:
a signal transmission unit configured to transmit the first signal to the second device; and
a signal acquisition unit configured to acquire the second signal from the second device,
wherein the second device forms a first closed circuit having the signal transmission unit and the signal acquisition unit as a start point and an end point, respectively,
wherein the apparatus is configured to cause the first signal to be transmitted through a second closed circuit in which the signal generator, the signal transmission unit, the first closed circuit, the signal acquisition unit, and the current controller are connected in series to each other.

9. The apparatus of claim 8, wherein, when the first signal is transmitted through the second closed circuit, the current controller is configured to adjust a current value in the second closed circuit to be equal to the given current value.

10. The apparatus of claim 9, wherein, when the first signal is transmitted through the second closed circuit, the given current value is greater than a current value caused by noise.

11. The apparatus of claim any preceding claim, wherein
the first device is a battery pack, and
the second device is an electronic device configured to be driven by the battery pack,
wherein the apparatus is configured to be connected in parallel to the first device and in series to the second device through the second device connection unit.

12. The apparatus of claim 11, wherein, before the first device is connected to the second device, the apparatus is configured to be connected in series to the second device through the second device connection unit and to verify the electrical connectivity between the first and second devices.

13. A method for verifying electrical connectivity between a first device and a second device, comprising:
providing an apparatus according to any preceding claim;
causing, by the processor, the signal generator to generate the first signal having a voltage waveform;
transmitting, by the second device connection unit, the first signal to the second device;
acquiring, by the second device connection unit, the second signal output from the second device in response to the first signal;
transmitting, by the processor connection unit, the first and second signals to the processor;
controlling, by the current controller, the magnitude of current such that the first signal has the given current value; and
verifying, by the processor, the electrical connectivity between the first and second devices based on the first and second signals received through the processor connection unit.

14. The method of claim 13, further comprising connecting the apparatus in parallel with the first device and in series with the second device through the second device connection unit.

15. The method of claim 14, further comprising, before the first device is connected to the second device:
connecting the apparatus in series to the second device through the second device connection unit; and
verifying the electrical connectivity between the first and second devices.

## Patentansprüche

1. Gerät (100) zum Verifizieren der elektrischen Konnektivität zwischen einer ersten Vorrichtung (200) und einer zweiten Vorrichtung (300), das Gerät umfassend:
einen Signalgenerator (110), konfiguriert zum Erzeugen eines ersten Signals, das eine Spannungswellenform aufweist;
einen Prozessor (140), konfiguriert zum Steuern des Signalgenerators;
eine Verbindungseinheit für die zweite Vorrichtung (120), konfiguriert zum Übertragen des ersten Signals an die zweite Vorrichtung und Erfassen eines von der zweiten Vorrichtung als Reaktion auf das erste Signal ausgegebenen zweiten Signals;
eine Prozessor-Verbindungseinheit (150), konfiguriert zum Übertragen des ersten und des zweiten Signals an den Prozessor;
eine Stromsteuerung (130), konfiguriert zum Steuern einer Größe von Strom derart, dass das erste Signal einen gegebenen Stromwert aufweist; und
der Prozessor konfiguriert zum Verifizieren der elektrischen Konnektivität zwischen der ersten und der zweiten Vorrichtung basierend auf den durch die Prozessor-Verbindungseinheit empfangenen ersten und zweiten Signalen.

2. Gerät nach Anspruch 1, wobei, wenn das durch die Prozessor-Verbindungseinheit empfangenen erste und zweite Signal miteinander korrespondieren, der Prozessor konfiguriert ist zum Bestimmen, dass die elektrische Konnektivität zwischen der ersten und der zweiten Vorrichtung verifiziert ist.

3. Gerät nach Anspruch 2, wobei das erste Signal ein im Voraus bestimmtes Charakteristikum aufweist, und
wenn das zweite Signal das im Voraus bestimmte Charakteristikum aufweist, der Prozessor konfiguriert ist zum Bestimmen, dass die elektrische Konnektivität zwischen der ersten und der zweiten Vorrichtung verifiziert ist.

4. Gerät nach Anspruch 3, wobei das erste Signal eine in der Zeit variierende Wellenform ist, die das im Voraus definierte Charakteristikum aufweist, und
wenn das zweite Signal eine in der Zeit variierende Wellenform ist, die das im Voraus bestimmte Charakteristikum aufweist, der Prozessor konfiguriert ist zum Bestimmen, dass die elektrische Konnektivität zwischen der ersten und der zweiten Vorrichtung verifiziert ist.

5. Gerät nach einem der vorhergehenden Ansprüche, wobei das erste Signal ein Rechteckwellensignal ist, das eine gegebene Periode aufweist, und
wenn das zweite Signal ein Rechteckwellensignal ist, das die gegebene Periode aufweist, der Prozessor konfiguriert ist zum Bestimmen, dass die elektrische Konnektivität zwischen der ersten und der zweiten Vorrichtung verifiziert ist.

6. Gerät nach einem der vorhergehenden Ansprüche, wobei das erste Signal mindestens eines einer in der Zeit variierenden Wellenform, die ein im Voraus bestimmtes Charakteristikum aufweist, und eines linearen Signals, das nur eine Leistungsversorgungsspannung aufweist, ist, und
wenn das zweite Signal ein lineares Signal ist, das nur eine Massespannung aufweist, der Prozessor konfiguriert ist zum Bestimmen, dass die erste und die zweite Vorrichtung in einem von einem Zustand, in dem die erste und die zweite Vorrichtung voneinander elektrisch getrennt sind, und von einem Zustand, in dem die zweite Vorrichtung mit Masse kurzgeschlossen ist, sind.

7. Gerät nach einem der vorhergehenden Ansprüche, wobei das erste Signal eine in der Zeit variierende Wellenform ist, die ein im Voraus bestimmtes Charakteristikum aufweist, und
wenn das zweite Signal ein lineares Signal ist, das nur eine Leistungsversorgungsspannung aufweist, der Prozessor konfiguriert ist zum Bestimmen, dass die zweite Vorrichtung mit einer Leistungsversorgung kurzgeschlossen ist.

8. Gerät nach einem der vorhergehenden Ansprüche, wobei die Verbindungseinheit für die zweite Vorrichtung umfasst:
eine Signalübertragungseinheit, konfiguriert zum Übertragen des ersten Signals an die zweite Vorrichtung; und
eine Signalerfassungseinheit, konfiguriert zum Erfassen des zweiten Signals von der zweiten Vorrichtung,
wobei die zweite Vorrichtung einen ersten geschlossenen Schaltkreis bildet, der die Signalübertragungseinheit und die Signalerfassungseinheit als Anfangspunkt bzw. Endpunkt aufweist,
wobei das Gerät konfiguriert ist zum Bewirken, dass das erste Signal durch einen zweiten geschlossenen Schaltkreis übertragen wird, in dem der Signalgenerator, die Signalübertragungseinheit, der erste geschlossene Schaltkreis, die Signalerfassungseinheit und die Stromsteuerung miteinander in Reihe verbunden sind.

9. Gerät nach Anspruch 8, wobei, wenn das erste Signal durch den zweiten geschlossenen Schaltkreis übertragen wird, die Stromsteuerung konfiguriert ist, einen Stromwert in dem zweiten geschlossenen Schaltkreis so anzupassen, dass er , gleich dem gegebenen Stromwert ist.

10. Gerät nach Anspruch 9, wobei, wenn das erste Signal durch den zweiten geschlossenen Schaltkreis übertragen wird, der gegebene Stromwert größer ist als ein durch Rauschen verursachter Stromwert.

11. Gerät nach einem der vorhergehenden Ansprüche, wobei
die erste Vorrichtung ein Batteriesatz ist, und
die zweite Vorrichtung eine elektronische Vorrichtung ist, die konfiguriert ist, um durch den Batteriesatz betrieben zu werden,
wobei das Gerät konfiguriert ist, parallel mit der ersten Vorrichtung und in Reihe mit der zweiten Vorrichtung durch die Verbindungseinheit für die zweite Vorrichtung verbunden zu werden.

12. Gerät nach Anspruch 11, wobei, bevor die erste Vorrichtung mit der zweiten Vorrichtung verbunden wird, das Gerät konfiguriert ist, um in Reihe mit der zweiten Vorrichtung durch die Verbindungseinheit für die zweite Vorrichtung verbunden zu werden und um die elektrische Konnektivität zwischen der ersten und der zweiten Vorrichtung zu verifizieren.

13. Verfahren zum Verifizieren von elektrischer Konnektivität zwischen einer ersten Vorrichtung und einer zweiten Vorrichtung, umfassend:
Bereitstellen eines Geräts nach einem der vorhergehenden Ansprüche;
Bewirken, durch den Prozessor, dass der Signalgenerator das erste Signal, das eine Spannungswellenform aufweist, erzeugt;
Übertragen, durch die Verbindungseinheit für die zweite Vorrichtung, des ersten Signals an die zweite Vorrichtung;
Erfassen, durch die Verbindungseinheit für die zweite Vorrichtung, des von der zweiten Vorrichtung als Reaktion auf das erste Signal ausgegebenen zweiten Signals;
Übertragen, durch die Prozessor-Verbindungseinheit, des ersten und des zweiten Signals an den Prozessor;
Steuern, durch die Stromsteuerung, der Größe von Strom derart, dass das erste Signal den gegebenen Stromwert aufweist; und
Verifizieren, durch den Prozessor, der elektrischen Konnektivität zwischen der ersten und der zweiten Vorrichtung basierend auf dem durch die Prozessor-Verbindungseinheit empfangenen ersten und zweiten Signal.

14. Verfahren nach Anspruch 13, ferner umfassend, das Gerät parallel mit der ersten Vorrichtung und in Reihe mit der zweiten Vorrichtung durch die Verbindungseinheit für die zweite Vorrichtung zu verbinden.

15. Verfahren nach Anspruch 14, ferner umfassend, bevor die erste Vorrichtung mit der zweiten Vorrichtung verbunden wird:
Verbinden des Geräts in Reihe mit der zweiten Vorrichtung durch die Verbindungseinheit für die zweite Vorrichtung; und
Verifizieren der elektrischen Konnektivität zwischen der ersten und der zweiten Vorrichtung.

## Revendications

1. Appareil (100) pour la vérification de connectivité électrique entre un premier dispositif (200) et un second dispositif (300), l'appareil comprenant:
un générateur de signal (110) configuré pour générer un premier signal ayant une forme d'onde de tension;
un processeur (140) configuré pour commander le générateur de signal;
une unité de connexion du second dispositif (120) configurée pour transmettre le premier signal au second dispositif et acquérir un second signal émis en sortie du second dispositif en réponse au premier signal;
une unité de connexion de processeur (150) configurée pour transmettre le premier et le second signal au processeur;
un contrôleur de courant (130) configuré pour commander une magnitude d'un courant de manière que le premier signal a une valeur de courant donnée; et
le processeur configuré pour vérifier la connectivité électrique entre le premier et le second dispositif sur la base du premier et du second signal reçus à travers l'unité de connexion de processeur.

2. Appareil selon la revendication 1, dans lequel, lorsque le premier et le second signal reçus à travers l'unité de connexion de processeur correspondent l'un à l'autre, le processeur est configuré pour déterminer que la connectivité électrique entre le premier et le second dispositif est vérifiée.

3. Appareil selon la revendication 2, dans lequel le premier signal a une caractéristique prédéterminée, et
lorsque le second signal a la caractéristique prédéterminée, le processeur est configuré pour déterminer que la connectivité électrique entre le premier et le second dispositif est vérifiée.

4. Appareil selon la revendication 3, dans lequel le premier signal est une forme d'onde variable dans le temps ayant ladite caractéristique prédéterminée, et
lorsque le second signal est une forme d'onde variable dans le temps ayant ladite caractéristique prédéterminée, le processeur est configuré pour déterminer que la connectivité électrique entre le premier et le second dispositif est vérifiée.

5. Appareil selon l'une quelconque des revendications précédentes, dans lequel le premier signal est un signal d'onde carrée ayant une période donnée, et
lorsque le second signal est un signal d'onde carrée ayant la période donnée, le processeur est configuré pour déterminer que la connectivité électrique entre le premier et le second dispositif est vérifiée.

6. Appareil selon l'une quelconque des revendications précédentes, dans lequel le premier signal est au moins l'un parmi une forme d'onde variable dans le temps ayant une caractéristique prédéterminée et un signal linéaire ayant seulement une tension d'alimentation électrique, et
lorsque le second signal est un signal linéaire ayant seulement une tension de masse, le processeur est configuré pour déterminer que le premier et le second dispositif se trouvent dans un état dans lequel le premier et le second dispositif sont déconnectés de manière électrique l'un de l'autre et un état dans lequel le second dispositif est court-circuité à la masse.

7. Appareil selon l'une quelconque des revendications précédentes, dans lequel le premier signal est une forme d'onde variable dans le temps ayant une caractéristique prédéterminée, et
lorsque le second signal est un signal linéaire ayant seulement une tension d'alimentation électrique, le processeur est configuré pour déterminer que le second dispositif est court-circuité à une alimentation électrique.

8. Appareil selon l'une quelconque des revendications précédentes, dans lequel l'unité de connexion du second dispositif comprend:
une unité d'émission de signal configurée pour émettre le premier signal au second dispositif; et
une unité d'acquisition de signal configurée pour acquérir le second signal du second dispositif,
dans lequel le second dispositif forme un premier circuit fermé ayant l'unité d'émission de signal et l'unité d'acquisition de signal comme respectivement, point de départ et point d'arrivée,
dans lequel l'appareil est configuré pour amener le premier signal à être émis à travers un second circuit fermé dans lequel le générateur de signal, l'unité d'émission de signal, le premier circuit fermé, l'unité d'acquisition de signal, et le contrôleur de courant sont connectés en série les uns aux autres.

9. Appareil selon la revendication 8, dans lequel, lorsque le premier signal est émis à travers le second circuit fermé, le contrôleur de courant est configuré pour ajuster une valeur de courant dans le second circuit fermé pour être égale à la valeur de courant donnée.

10. Appareil selon la revendication 9, dans lequel, lorsque le premier signal est émis à travers le second circuit fermé, la valeur de courant donnée est supérieure à une valeur de courant causée par du bruit.

11. Appareil selon l'une quelconque des revendications précédentes, dans lequel le premier dispositif est un bloc batterie, et
le second dispositif est un dispositif électronique configuré pour être alimenté par le bloc batterie,
dans lequel l'appareil est configuré pour être connecté en parallèle au premier dispositif et en série au second dispositif à travers l'unité de connexion du second dispositif.

12. Appareil selon la revendication 11, dans lequel, avant que le premier dispositif soit connecté au second dispositif, l'appareil est configuré pour être connecté en série au second dispositif à travers l'unité de connexion du second dispositif et pour vérifier la connectivité électrique entre le premier et le second dispositif.

13. Procédé pour la vérification de connectivité électrique entre un premier dispositif et un second dispositif, comprenant:
la fourniture d'un appareil selon l'une quelconque des revendications précédentes;
le fait d'amener, par le processeur, le générateur de signal à générer le premier signal ayant une forme d'onde de tension;
l'émission, par l'unité de connexion du second dispositif, du premier signal au second dispositif;
l'acquisition, par l'unité de connexion du second dispositif, du second signal émis en sortie du second dispositif en réponse au premier signal;
l'émission, par l'unité de connexion de processeur, du premier et du second signal au processeur;
la commande, par le contrôleur de courant, de la magnitude du courant de manière que le premier signal a la valeur de courant donnée; et
la vérification, par le processeur, de la connectivité électrique entre le premier et le second dispositif sur la base du premier et du second signal reçus à travers l'unité de connexion de processeur.

14. Procédé selon la revendication 13, comprenant en outre la connexion de l'appareil en parallèle avec le premier dispositif et en série avec le second dispositif à travers l'unité de connexion du second dispositif.

15. Procédé selon la revendication 14, comprenant en outre, avant que le premier dispositif soit connecté au second dispositif:
la connexion de l'appareil en série au second dispositif à travers l'unité de connexion du second dispositif; et
la vérification de la connectivité électrique entre le premier et le second dispositif.
